# EUROPÄISCHE PATENTSCHRIFT

(11) **EP 4 350 370 B1**
(45) Veröffentlichungstag und Bekanntmachung des Hinweises auf die Patenterteilung: **22.07.2026**
(21) Anmeldenummer: 22199827.1
(22) Anmeldetag: 05.10.2022
(51) Int. Cl.: G01R 15/16, G01R 31/312, H04B 3/46, H04L 12/12, G01R 1/07, G01R 1/067, G01R 29/12, G01R 31/00, G01R 31/28, H04B 5/22

(54) **MESSVORRICHTUNG ZUR ERFASSUNG ELEKTRISCHER SIGNALE EINER DATENVERBINDUNG**
MEASURING DEVICE FOR DETECTING ELECTRICAL SIGNALS OF A DATA CONNECTION
DISPOSITIF DE MESURE POUR L'ACQUISITION DE SIGNAUX ÉLECTRIQUES D'UNE LIAISON DE DONNÉES

(43) Veröffentlichungstag der Anmeldung: 10.04.2024
(73) Patentinhaber: Murrelektronik GmbH, 71570 Oppenweiler (DE)
(72) Erfinder: Seidel, Jens, 04509 Delitzsch (DE)
(74) Vertreter: Karzel, Philipp

(56) Entgegenhaltungen:
- EP-A1- 3 657 734
- US-A1- 2011 199 229
- US-A1- 2016 134 705
- US-A1- 2017 317 716

## Beschreibung

Die Erfindung betrifft eine Messvorrichtung, die ausgebildet ist, auf einer elektrischen Leitung übertragene elektrische Signale zu erfassen. Es soll das auf einer elektrischen Leitung gesendete Protokoll einer Datenverbindung erfasst werden, um es einer Signalauswerteeinheit zuzuführen.

Bei IO-Link-Verbindungen handelt es sich um sogenannte "Punkt zu Punkt-Verbindungen" zur Kommunikation zwischen Mastereinheiten und Devices, die meist als Aktoren und/oder Sensoren ausgebildet sind. Die elektrischen Leitungen zwischen den Mastereinheiten und Devices sind z. B. als 4- bis 5-polige Leitungen ausgeführt, die zudem oft ungeschirmt sind.

In der Praxis können Kommunikationsprobleme zwischen den Mastereinheiten und den Devices auftreten. Dies kann zu fehlerhaften Bedienungen der Aktoren und/oder zu verzögerten oder fehlenden Sensorsignalen führen. Dies kann durch eine fehlerhafte Umsetzung des von der Mastereinheit zum Device oder in Gegenrichtung übermittelten Protokolls auftreten. Sind darüber hinaus innerhalb des IO-Link-Systems Gateway-Geräte, z. B. ein Profinet-IO-Link-Master oder dgl. Zusatzgeräte verwendet, kann dies bei der Übermittlung des Protokolls zwischen den Devices und den Mastereinheiten zu Zeitverzögerungen kommen, die Fehlfunktionen auslösen können.

Es ist bekannt, die elektrische Leitung der Datenverbindung, z. B. die IO-Link-Verbindung zu öffnen, um eine Messvorrichtung wie z. B. einen Protokoll-Analyzer zwischenzuschalten, also ein Messgerät in die Leitung einzuschleifen. Da die in einer industriellen IO-Link-Anlage vorgesehenen elektrischen Leitungen oft fest verdrahtet oder mit M12- und/oder M8-Steckern verbunden sind, müssen diese geöffnet werden, um ein Messgerät einzuschleifen. Steckverbindungen müssen gelöst und wieder aufgesteckt werden. Ein zur Fehleranalyse notwendiges An- und Abstecken der elektrischen Leitung ist unpraktikabel und kostet den Betreiber der Industrieanlage Zeit und Geld. Da ein Öffnen der IO-Link-Verbindung in der Regel zum Rücksetzen der integrierten State Machines führt, entspricht dieses häufig einem Reset. Der Zustand des Fehlers ist dadurch oftmals auch zurückgesetzt. Dieses ist insbesondere bei sporadisch auftretenden Fehlern ein Problem.

Darüber hinaus können selten auftretende Fehler häufig nur mit einer eingeschleiften Messvorrichtung und nur nach Rücksetzen des Protokoll-Analyzers erfasst werden. Ein sporadisch auftretender Fehler kann häufig nur durch einen vom Start der Anlage an bis zum Auftreten des Fehlers betriebenen Protokoll-Analyzer erfasst werden. Die Anlage muss nach dem Einschleifen der Messvorrichtung über eine lange Betriebsdauer betrieben werden, um gesuchte sporadische oder selten auftretende Fehler feststellen zu können. Da es Tage und auch Wochen dauern kann, bis z. B. ein gesuchter sporadischer Fehler auftritt, ist diese Lösung umständlich und aufwendig.

Von erheblichem Nachteil ist auch, dass bei einem Öffnen der elektrischen Leitungen die industrielle Anlage selbst zumindest kurzzeitig angehalten werden muss, bis die Messvorrichtung installiert bzw. deinstalliert ist.

Aus der US 2017/0317716 A1 geht ein Verfahren zum kontaktlosen Abgreifen von Kommunikationssignalen als bekannt hervor, bei der ein Werkzeug mit einer Vielzahl von Elektroden über den Umfang eines Kommunikationskabels angeordnet werden. Mehrere Elektroden werden elektrisch zu Sammelelektroden verschaltet, was einen erheblichen mechanischen und elektrischen Aufwand bedingt.

Die US 2011/0199229 A1 offenbart einen Sensor zur Verwendung an einem CAN-Bus, bei dem ein zusammensteckbarer Sensor eine einheitliche Kondensatorplatte bildet.

Die US 2016/0134705 A1 beschreibt einen digitalen Sensor für einen CAN-Bus, der als Gehäuse ausgebildet ist, durch welches die beiden CAN-Bus Leitungen geführt und deren elektromagnetischen Felder kapazitiv erfasst werden. Die Leitungen des CAN-Bus müssen in Öffnungen des Gehäuses eingefädelt und das Gehäuse mit einer Messelektronik fest verschlossen werden. Die ist umständlich und macht den Einsatz an verschiedenen Messstellen aufwendig und zeitraubend.

In der EP 3 657 734 A1 wird ein Verfahren beschrieben, die IO-Link Daten kapazitiv auszukoppeln Dazu wird eine leitende Hülle um ein IO-Link Kabel gelegt, wobei die erhaltenen Signale stark verformt und mit Störungen behaftet sind. Mit hohem Aufwand müssen die Signale aufbereitet werden, um diese auszuwerten zu können.

Der Erfindung liegt die Aufgabe zugrunde, eine einfach aufgebaute Messvorrichtung anzugeben, mit der eine Erfassung und Auswertung von in einer IO-Leitung übertragenen elektrischen Signale einer Datenverbindung möglich ist, ohne die elektrische Leitung selbst zu öffnen.

Nach der Erfindung ist die Messvorrichtung zur elektrisch kontaktlosen Erfassung übertragener elektrischer Signale auf einer IO-Leitung ausgebildet. Die Messvorrichtung umfasst einen Messfühler aus zumindest zwei oder mehr Elektroden, die elektrisch an eine Signalauswerteeinheit angeschlossen sind. Zwei Elektroden liegen mit einem Abstand zueinander und bilden einen Kondensator, wobei zwischen den beiden Elektroden des Kondensators ein Messraum ausgebildet ist. Die elektrische Leitung verläuft mit zumindest einem Leitungsabschnitt zwischen den Elektroden durch den Messraum.

Die Elektroden sind zueinander beweglich gehalten und bilden die Backen einer Messzange. Die Messzange ist derart ausgebildet, dass die Längsränder der von den Elektroden gebildeten Flächen in Schließstellung der Messzange einander mit Abstand gegenüber liegen. Der Abstand ist kleiner als der Durchmesser des Leitungsabschnittes, wodurch eine enge räumliche Lage der Elektroden zum Leitungsabschnitt gegeben ist, was eine gute kapazitive Kopplung gewährleistet.

Mit der erfindungsgemäßen Ausbildung der Messvorrichtung kann das auf der elektrischen Leitung übertragene Protokoll einer Datenverbindung ohne Öffnen der elektrischen Leitung selbst abgegriffen werden. Die Signale in der elektrischen Leitung werden durch die Elektroden als elektrostatische Felder festgestellt und können über eine Signalauswerteeinheit von den Elektroden als elektrische Potentiale abgegriffen und ausgewertet werden. So kann ohne Öffnung der elektrischen Leitung und ohne Eingriff in die Anlage selbst festgestellt werden, ob die über die elektrischen Leitungen transportierten Protokolle zeitlich und inhaltlich korrekt sind. Ein Stillstand der Anlage ist vermieden. Auch seltene oder sporadisch auftretende Fehler können einfach ermittelt werden, da erst im Falle eines sporadisch auftretenden Fehlers die entsprechende elektrische Leitung zwischen einer Mastereinheit und einem Device durch Anordnung der Messvorrichtung kontaktlos und ohne Öffnen der Leitung überprüft werden kann.

Die Erfindung lässt sich nicht nur bei IO-Link-Verbindungen nutzen, sondern bei jeder Kommunikation in einer ungeschirmten elektrischen Leitung, so z. B. auch bei folgenden Systemen:

### • DALI (Digital Addressable Lighting Interface)

In der Gebäudeautomatisierung ist dies ein Protokoll zur Steuerung von lichttechnischen Betriebsgeräten, wie z. B. Schaltnetzteilen ("elektronischer Transformator"), elektronischen Vorschaltgeräten (EVG) oder elektronischen Leistungsdimmern.

### • LIN (Local Interconnect Network)

Dieses auch LIN-Bus genanntes System ist ein serielles Kommunikationssystem für die Vernetzung von Sensoren und Aktoren. Typische Anwendungsbeispiele sind die Vernetzung innerhalb der Tür oder des Sitzes eines Kraftfahrzeugs.

Auch ist mit der erfindungsgemäßen Messvorrichtung eine Analyse von PWM-Signalen (Pulsweitenmodulation) möglich. Derartige Signale werden z. B. zur Ansteuerung von Proportionalventilen genutzt.

Zweckmäßig sind zwei einander mit einem vorgegebenen Abstand gegenüberliegende Elektroden vorgesehen, die einen definierten Messraum begrenzen.

In Weiterbildung der Erfindung ist eine Elektrode des Messfühlers am Ende eines ersten Zangenarms und die andere Elektrode am Ende eines zweiten Zangenarms angeordnet. Die beiden Zangenarme sind über ein Gelenk miteinander verbunden, wobei zwischen den Zangenarmen ein Abstandshalter angeordnet ist, um bei geschlossener Messzange einen Kontakt der Elektroden zu vermeiden.

Zweckmäßig erstrecken sich die Elektroden über eine vorgegebene Länge in Längsrichtung des Leitungsabschnittes und über eine vorgegebene Breite quer zur Längsrichtung des Leitungsabschnittes. Dabei ist der zwischen den Elektroden gebildete Messraum in der Länge und in der Breite frei skalierbar.

Die Elektroden der Messeinrichtung bestehen aus einem elektrisch leitfähigen Material. Bevorzugt ist das Material Metall oder eine Metalllegierung.

In Weiterbildung der Erfindung ist vorgesehen, dass eine Elektrode eine Fläche aufspannt, die sich längs und quer zum Leitungsabschnitt erstreckt. Die Fläche ist in Umfangsrichtung des Leitungsabschnittes bevorzugt gewölbt ausgebildet. Dadurch ist eine hohe kapazitive Kopplung der Messeinrichtung mit dem Leitungsabschnitt erzielt. Der Leitungsabschnitt der elektrischen Leitung weist bevorzugt mehrere Adern auf, insbesondere 4 bis 5 Adern.

Weitere Merkmale der Erfindung ergeben sich aus den weiteren Ansprüchen, der Beschreibung und der Zeichnung, in der ein Ausführungsbeispiel der Erfindung wiedergegeben ist. Es sei ausdrücklich darauf hingewiesen, dass die in den Ansprüchen genannten Merkmale, die in der Beschreibung wiedergegebenen Merkmale und die in den Zeichnungen dargestellten Merkmale untereinander kombinierbar sind. In den Zeichnungen zeigen:
- Fig. 1: eine schematische Darstellung der erfindungsgemäßen Messvorrichtung an einer elektrischen Leitung zwischen einer Mastereinheit und einem Device,
- Fig. 2: eine schematische, perspektivische Darstellung der Anordnung von Elektroden der erfindungsgemäßen Messvorrichtung an einer elektrischen Leitung,
- Fig. 3: eine Darstellung der Anordnung der Elektroden der Messvorrichtung an einer elektrischen Leitung,
- Fig. 4: eine schematische Darstellung einer Messzange mit Elektroden der erfindungsgemäßen Messvorrichtung,
- Fig. 5: ein Diagramm einer Signalfolge von auf einer elektrischen Leitung gesendeten Signalen S1, S2, .... Sn auf einer Zeitachse t,
- Fig. 6: ein Diagramm einer Signalfolge der von der erfindungsgemäßen Messvorrichtung über den Messfühler abgegriffenen Messsignale M₁, M₂, ... Mₙ auf einer Zeitachse t.

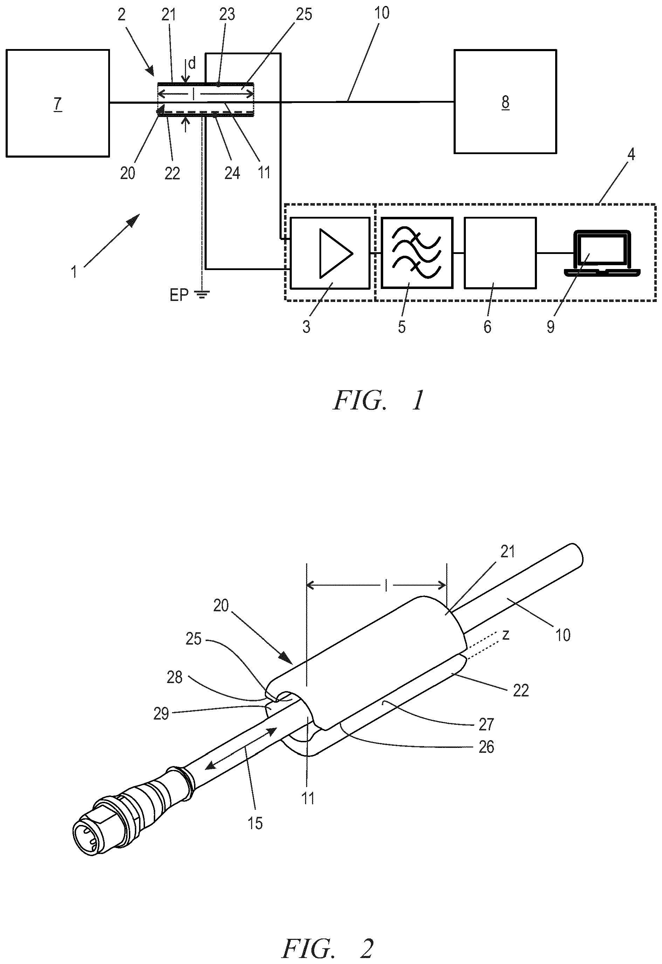

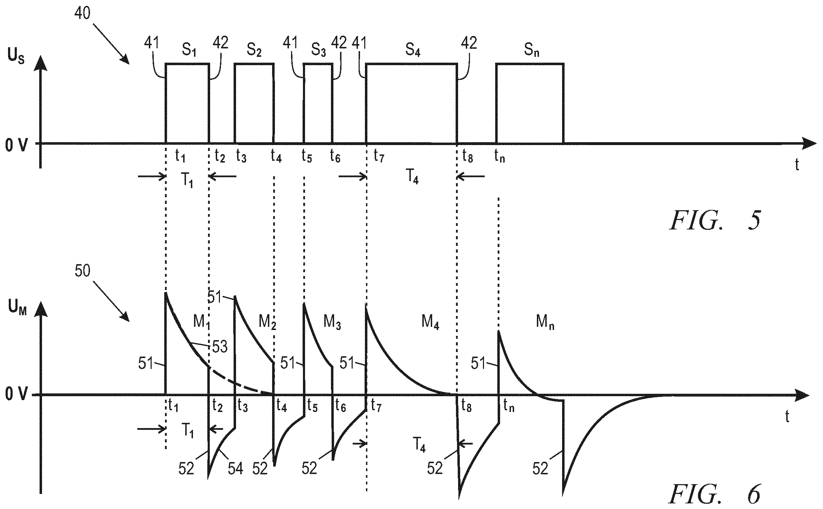

In dem schematischen Blockschaltbild nach Fig. 1 ist eine elektrische Leitung 10 zwischen einer Mastereinheit 7 und einem Device 8 dargestellt. Die elektrische Leitung 10 ist insbesondere die elektrischen Leitung 10 einer IO-Link-Verbindung. An der Leitung 10 ist ein Messfühler 2 einer Messvorrichtung 1 angeordnet, die geeignet und ausgebildet ist, die in der elektrischen Leitung 10 übermittelten elektrischen Signale S₁, S₂, .... Sₙ (Fig. 5) kontaktlos elektrisch zu erfassen.

Die erfindungsgemäße Messvorrichtung 1 kann allgemein genutzt werden, insbesondere die Flanken der elektrischen Signale S₁, S₂, .... Sₙ auf einer elektrischen Leitung 10 als Messsignale M₁, M₂, ... Mₙ (Fig. 6) zu erfassen, um diese in einer nachgeordneten Signalauswerteeinheit 4 auszuwerten. Insbesondere kann die Änderung der auf der Leitung gesendeten elektrischen Größe eines Signals erfasst werden. Bei einer Übertragung von Daten kommt es in erster Linie auf die Flanken des übertragenen Signals an, so z. B. auf den Peak des Signals oder dessen Anstieg oder Abfall. Dies kann mit der erfindungsgemäßen Messvorrichtung 1 sicher erfasst werden.

Der Messfühler 2 der erfindungsgemäßen Messvorrichtung 1 besteht aus zumindest zwei Elektroden 21 und 22, die im gezeigten Ausführungsbeispiel nach Fig. 1 mit Abstand d einander gegenüber liegen.

Auch der Einsatz von mehr als zwei Elektroden ist denkbar. Mit mehr als zwei Elektroden besteht die Möglichkeit, in einer elektrischen Leitung mit mehreren Kommunikationskanälen eine Lokalisierung des Kommunikationskanals in der Leitung 10 durchzuführen. Durch die Auswertung der einzelnen zwischen den Elektroden erfassten Spannungssignale kann das erfasste Signal bzw. dessen Signalform einer konstruktiven Position des Kommunikationskanals in der elektrischen Leitung 10 zugeordnet werden.

Die Elektroden 21 und 22 sind über einen Verstärker 3 an die Signalauswerteeinheit 4 angeschlossen. Die Signalauswerteeinheit 4 weist ferner einen Frequenzfilter 5 auf, mit dem Störfrequenzen des Messfühlers 2 ausgefiltert werden. Über eine Signalaufbereitung 6 wird das erfasste Signal des Messfühlers 2 in einem Endgerät 9, z. B. einem PC, einem Laptop oder einem Tablett verarbeitet und auf Fehler ausgewertet.

Die Elektroden 21 und 22 des Messfühlers 2 liegen mit einem Abstand d zueinander. Zwischen den Elektroden 21 und 22 ist ein Messraum 25 ausgebildet, durch den ein Leitungsabschnitt 11 der elektrischen Leitung 10 verläuft.

Die Elektroden 21, 22 bilden zusammen mit dem Messraum 25 einen Kondensator 20. Vorzugsweise bilden die Elektroden 21, 22 Platten 23 und 24 eines idealisierten Plattenkondensators. Der Kondensator 20 umgreift die Leitung 10 und ist kapazitiv an den Leitungsabschnitt 11 der elektrischen Leitung 10 angekoppelt. Durch die kapazitive Kopplung werden die über den Leitungsabschnitt 11 übermittelten elektrischen Signale elektrisch kontaktlos erfasst und können über die Signalauswerteeinheit 4 ausgewertet werden.

Fig. 5 zeigt eine Signalfolge 40 aus Signalen S₁, S₂, .... Sₙ auf einer elektrischen Leitung 10. Jedes Signal S₁, S₂, .... Sₙ der Signalfolge 40 hat eine ansteigende Flanke 41 und eine abfallende Flanke 42. Die Höhe eines Signals S₁, S₂, .... Sₙ entspricht einem vorgegebenen Spannungspegel von z. B. 5 V. Die Signalfolge 40 kann auch als Impulsfolge bezeichnet werden. In anderen Datenverbindungen wie IO-Link liegt der Spannungspegel bei 24V. Ein andere Bus wie ein LIN-Bus hat einen Spannungspegel von 12V. Ein DALI-Bus hat einen Spannungspegel zwischen 9,5 und 22,5 V.

Diese über die elektrische Leitung 10 übermittelte Signalfolge 40 initiiert in dem als Kondensator 20 ausgeführten Messfühler 2 eine Signalfolge 40 aus Messsignalen M₁, M₂, ... Mₙ, wie sie in Fig. 6 dargestellt sind. Die positive Spannungsänderung der im Zeitpunkt t₁ ansteigenden Flanke 41 eines gesendeten Signals S₁ löst im gleichen Zeitpunkt t₁ eine positive Spannungsflanke 51 im Kondensator 20 aus. Die positive Spannungsflanke 51 fällt nach einer Entladekurve 53 des Kondensators 20 wieder ab. Die im Zeitpunkt t₂ abfallende Flanke 42 des gesendeten Signals S₁ löst im Kondensator 20 eine negative Spannungsflanke 52 aus, wie Fig. 6 zeigt. Die negative Spannungsflanke 52 fällt nach einer Entladekurve 53 des Kondensators 20 wieder ab. Der Abstand der positiven Spannungsflanke 51 zur negativen Spannungsflanke 52 entspricht der Impulsdauer T₁ des gesendeten Signals S₁. Über die erfindungsgemäße Messvorrichtung 1 kann kontaktlos der Zeitpunkt tₙ einer ansteigenden Flanke 41 und der Zeitpunkt tₙ einer abfallenden Flanke 42 bestimmt werden. Aus den Zeitpunkten tₙ kann die Pulsform eines gesendeten Signals S₁, S₂, .... Sₙ abgeleitet werden. Mit einer der Messvorrichtung 1 nachgeschalteten Signalauswerteeinheit 4 ist es grundsätzlich auch möglich, den Spannungspegel Us der gesendeten Signale S₁, S₂, .... Sₙ, also die Impulshöhe der gesendeten Signale S₁, S₂, .... Sₙ zu bestimmen.

Wie sich aus der Zusammenschau der Figuren 1 bis 3 ergibt, erstrecken sich die Elektroden 21 und 22 über eine vorgegebene Länge l in Längsrichtung 15 der elektrischen Leitung 10 und über eine vorgegebene Breite b quer zur Längsrichtung 15 des Leitungsabschnittes 11.

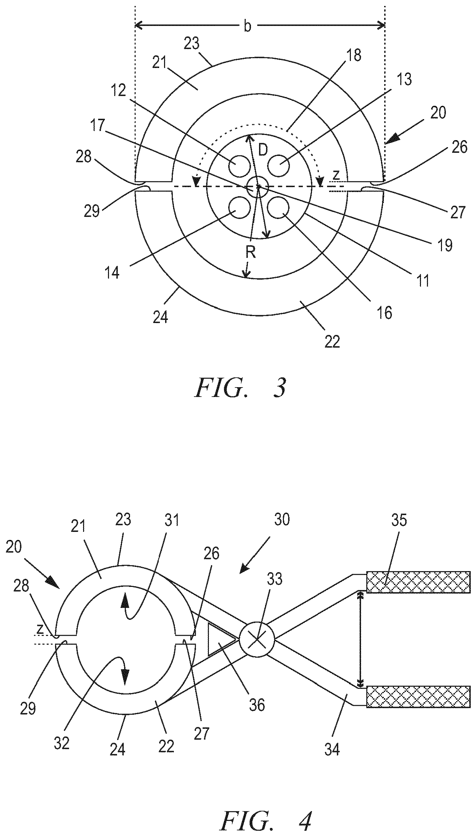

Die Elektroden 21 und 22 können jede geeignete Form aufweisen, z. B. als Platten, als Formkörper oder dgl. ausgebildet sein. Wie die Figuren 2 und 3 zeigen, spannt jede Elektrode 21, 22 eine Fläche auf, welche sich längs und quer zum Leitungsabschnitt 11 erstreckt. Die Fläche der Elektrode 21 weist Längsränder 26 und 28 auf. Die Fläche der Elektrode 22 weist Längsränder 27 und 29 auf.

Vorzugsweise ist die Fläche einer Elektrode 21, 22 quer zum Leitungsabschnitt 11 gewölbt ausgebildet. Quer zum Leitungsabschnitt 11, oder in Umfangsrichtung zum Leitungsabschnitt 11 wird der Leitungsabschnitt 11 durch die Fläche der Elektroden 21 oder 22 zumindest teilweise umhüllt. Sind beide Elektroden 21 und 22 gewölbt ausgebildet, kann der Leitungsabschnitt 11 über 330° bis 350° eingeschlossen werden, vorzugsweise bis zu 360°.

Ist die Leitung 10, wie in den Figuren 2 und 3 dargestellt, ein Rundkabel mit mehreren Adern 12, 13, 14, 16 und 17, kann es zweckmäßig sein, die Flächen der Elektroden 21 und 22 mit einem Wölbungsradius R auszubilden, dessen Kreismittelpunkt vorteilhaft mit der Längsmittelachse 19 des Rundkabels zusammenfällt. Der Wölbungsradius R kann dem halben Durchmesser D des Leitungsabschnittes 11 entsprechen. Bevorzugt ist der Wölbungsradius größer als der halbe Durchmesser D des Leitungsabschnittes 11 ausgebildet, z. B. 1,5 bis 3fach größer.

Mit dem Messfühler 2 der erfindungsgemäßen Messvorrichtung 1 können die auf den Adern 12, 13, 14, 16 und 17 gesendeten elektrischen Signale S₁, S₂, .... Sₙ einer Signalfolge 40 kapazitiv und damit elektrisch kontaktlos erfasst werden. Über das den Elektroden 21 und 22 nachgeordnete Frequenzfilter 5 ist eine Selektion der vom Messfühler 2 erfassten Signalfolge 50 aus Messsignalen M₁, M₂, ... Mₙ möglich, so dass die auf einer ausgewählten Ader 12, 13, 14, 16 und 17 gesendeten Signale S₁, S₂, .... Sₙ selektiv ausgewählt und als Messsignale M₁, M₂, ... Mₙ in der Signalauswerteeinheit 4 ausgewertet werden können.

Die Elektroden 21 und 22 des Messfühlers 2 der erfindungsgemäßen Messvorichtung 1 sind zueinander beweglich gehalten. Der Benutzer hat die Möglichkeit, den Abstand der Elektroden 21 und 22 zu verändern. Dies kann vorteilhaft sein, um eine möglichst gute kapazitive Kopplung des Messfühlers 2 mit dem Leitungsabschnitt 11 der elektrischen Leitung 10 zu erzielen.

In der erfindungsgemäßen Messvorichtung 1 bilden die Elektroden 21 und 22 die Backen 31 und 32 einer Messzange 30 zur Einkopplung von Signalen einer elektrischen Leitung 10 bei gleichzeitiger Einkopplungsdämpfung von Signalen benachbarter Leitungen.

In einer bevorzugten Ausführungsform ist eine Elektrode 21 des Messfühlers 2 am Ende eines ersten Zangenarms 34 angeordnet. Die andere Elektrode 22 ist am Ende eines zweiten Zangenarms 35 angeordnet. Die beiden Zangenarme 34 und 35 sind über ein Gelenk 33 miteinander verbunden.

Um bei geschlossener Messzange 30 einen Kontakt der Backen 31 und 32 bzw. der Elektroden 21 und 22 zu vermeiden, ist zwischen den Zangenarmen ein Abstandshalter 36 angeordnet. Der Abstandshalter 36 gewährleistet, dass die Längsränder 26 und 28 der Elektrode 21 von den Längsrändern 27 und 29 der Elektrode 22 mit einem Abstand z zueinander liegen. Der Abstand z ist so gewählt, dass die Elektroden 21 und 22 den Leitungsabschnitt 11 über einen großen Umfangswinkel 18 von 330° bis 350°, vorzugsweise bis 360° umschließen. Eine hohe kapazitive Kopplung des Messfühlers 2 kann so erzielt werden.

Durch die kapazitive Signalerfassung der Signale S₁, S₂, .... Sₙ einer Signalfolge 40 und die nachfolgende Aufbereitung der Signalfolge 50 der erfassten Messsignale M₁, M₂, ... Mₙ ist eine Auswertung durch Protokollanalysatoren oder geeigneten Schaltungen möglich.

## Patentansprüche

1. Messvorrichtung, ausgebildet zur Erfassung von in einer elektrischen Leitung (10) übertragenen elektrischen Signalen von Protokollen einer Datenverbindung wie einer IO-Link Verbindung, wobei die Messvorrichtung (1) zur elektrisch kontaktlose Erfassung übertragener elektrischer Signale ausgebildet ist, und die Messvorrichtung (1) aus einem Messfühler (2) mit zumindest zwei Elektroden (21, 22) besteht, die elektrisch an eine Signalauswerteeinheit (4) angeschlossen sind, und die Elektroden (21, 22) mit einem Abstand (d) zueinander liegen und einen Kondensator (20) bilden, zwischen dessen Elektroden (21, 22) ein Messraum (25) ausgebildet ist, wobei die Messvorrichtung (1) dazu eingerichtet ist, dass die elektrische Leitung (10) mit zumindest einem Leitungsabschnitt (11) zwischen den Elektroden (21, 22) durch den Messraum (25) verläuft. **dadurch gekennzeichnet, dass** die Elektroden (21, 22) zueinander beweglich gehalten sind und die Backen (31, 32) einer Messzange (30) bilden, wobei die Elektroden (21, 22) Längsränder (26,27, 28, 29) haben und die Längsränder (26,27, 28, 29) der Elektroden (21, 22) in Schließstellung der Messzange (30) einander mit Abstand (z) gegenüber liegen, wobei der Abstand (z) kleiner ist als der Durchmesser (D) des Leitungsabschnittes (11).

2. Messvorrichtung nach Anspruch 1,
**dadurch gekennzeichnet, dass** eine Elektrode (21) des Messfühlers (2) am Ende eines ersten Zangenarms (34) angeordnet ist, und die andere Elektrode (22) am Ende eines zweiten Zangenarms (35) angeordnet ist, und die beiden Zangenarme (34, 35) über ein Gelenk (33) miteinander verbunden sind, und zwischen den Zangenarmen (34, 35) ein Abstandshalter (36) angeordnet ist, um bei geschlossener Messzange (30) einen Kontakt der Elektroden (21, 22) zu vermeiden.

3. Messvorrichtung nach Anspruch 1 oder 2,
**dadurch gekennzeichnet, dass** sich die Elektroden (21, 22) über eine vorgegebene Länge (l) in Längsrichtung (5) des Leitungsabschnittes (11) und über eine vorgegebene Breite (b) quer zur Längsrichtung (5) des Leitungsabschnittes (11) erstrecken.

4. Messvorrichtung nach einem der Ansprüche 1 bis 3,
**dadurch gekennzeichnet, dass** die Elektrode (21, 22) aus einem elektrisch leitfähigen Material, insbesondere aus Metall oder einer Metalllegierung bestehen.

5. Messvorrichtung nach einem der Ansprüche 1 bis 4,
**dadurch gekennzeichnet, dass** eine Elektrode (21, 22) eine Fläche aufspannt, die in Umfangsrichtung (13) des Leitungsabschnittes (11) gewölbt ausgebildet ist.

6. Messvorrichtung nach einem der Ansprüche 1 bis 5,
**dadurch gekennzeichnet, dass** die Leitung (11) mehrere Leitungsadern (12, 13, 14, 16, 17) aufweist.

## Claims

1. Measuring device configured to detect electrical signals transmitted in an electrical line (10) of protocols of a data connection such as an IO-Link connection, wherein the measuring device (1) is configured for electrically contactless detection of transmitted electrical signals, and the measuring device (1) consists of a measuring sensor (2) having at least two electrodes (21, 22), which are electrically connected to a signal evaluation unit (4), and the electrodes (21, 22) are spaced apart from one another by a distance (d) and form a capacitor (20), between the electrodes (21, 22) of which a measuring space (25) is formed, wherein the measuring device (1) is configured such that the electrical line (10), with at least one line section (11), extends through the measuring space (25) between the electrodes (21, 22),
**characterized in that** the electrodes (21, 22) are held movably relative to one another and form the jaws (31, 32) of a measuring clamp (30), wherein the electrodes (21, 22) have longitudinal edges (26, 27, 28, 29), and the longitudinal edges (26, 27, 28, 29) of the electrodes (21, 22), in the closed position of the measuring clamp (30), lie opposite one another at a distance (z), wherein the distance (z) is smaller than the diameter (D) of the line section (11).

2. Measuring device according to claim 1,
**characterized in that** one electrode (21) of the measuring sensor (2) is arranged at the end of a first clamp arm (34), and the other electrode (22) is arranged at the end of a second clamp arm (35), and the two clamp arms (34, 35) are connected to one another via a joint (33), and a spacer (36) is arranged between the clamp arms (34, 35) in order to avoid contact of the electrodes (21, 22) when the measuring clamp (30) is closed.

3. Measuring device according to claim 1 or 2,
**characterized in that** the electrodes (21, 22) extend over a predefined length (l) in the longitudinal direction (5) of the line section (11) and over a predefined width (b) transversely to the longitudinal direction (5) of the line section (11).

4. Measuring device according to one of claims 1 to 3,
**characterized in that** the electrode (21, 22) consists of an electrically conductive material, in particular of metal or a metal alloy.

5. Measuring device according to one of claims 1 to 4,
**characterized in that** one electrode (21, 22) spans a surface which is of curved configuration in the circumferential direction (13) of the line section (11).

6. Measuring device according to one of claims 1 to 5,
**characterized in that** the line (10) has a plurality of line cores (12, 13, 14, 16, 17).

## Revendications

1. Dispositif de mesure conçu pour détecter des signaux électriques transmis dans une ligne électrique (10) de protocoles d'une liaison de données telle qu'une liaison IO-Link, le dispositif de mesure (1) étant conçu pour la détection électriquement sans contact de signaux électriques transmis, et le dispositif de mesure (1) étant constitué d'un capteur de mesure (2) ayant au moins deux électrodes (21, 22), qui sont raccordées électriquement à une unité d'évaluation de signal (4), et les électrodes (21, 22) étant situées à une distance (d) l'une de l'autre et formant un condensateur (20), un espace de mesure (25) étant formé entre les électrodes (21, 22) duquel, le dispositif de mesure (1) étant conçu de telle sorte que la ligne électrique (10), avec au moins une section de ligne (11), s'étend à travers l'espace de mesure (25) entre les électrodes (21, 22), **caractérisé en ce que** les électrodes (21, 22) sont maintenues mobiles l'une par rapport à l'autre et forment les mors (31, 32) d'une pince de mesure (30), les électrodes (21, 22) ayant des bords longitudinaux (26, 27, 28, 29), et les bords longitudinaux (26, 27, 28, 29) des électrodes (21, 22), en position fermée de la pince de mesure (30), étant disposés l'un en face de l'autre à une distance (z), la distance (z) étant inférieure au diamètre (D) de la section de ligne (11).

2. Dispositif de mesure selon la revendication 1,
**caractérisé en ce qu'**une électrode (21) du capteur de mesure (2) est disposée à l'extrémité d'un premier bras de pince (34), et l'autre électrode (22) est disposée à l'extrémité d'un second bras de pince (35), et les deux bras de pince (34, 35) sont reliés l'un à l'autre via une articulation (33), et un élément d'espacement (36) est disposé entre les bras de pince (34, 35) afin d'éviter un contact des électrodes (21, 22) lorsque la pince de mesure (30) est fermée.

3. Dispositif de mesure selon la revendication 1 ou 2,
**caractérisé en ce que** les électrodes (21, 22) s'étendent sur une longueur prédéfinie (l) dans la direction longitudinale (5) de la section de ligne (11) et sur une largeur prédéfinie (b) transversalement à la direction longitudinale (5) de la section de ligne (11).

4. Dispositif de mesure selon l'une des revendications 1 à 3,
**caractérisé en ce que** l'électrode (21, 22) est constituée d'un matériau électriquement conducteur, notamment de métal ou d'un alliage métallique.

5. Dispositif de mesure selon l'une des revendications 1 à 4,
**caractérisé en ce qu'**une électrode (21, 22) délimite une surface qui est configurée de manière courbée dans la direction circonférentielle (13) de la section de ligne (11).

6. Dispositif de mesure selon l'une des revendications 1 à 5,
**caractérisé en ce que** la ligne (10) comporte plusieurs conducteurs de ligne (12, 13, 14, 16, 17).
